# FASCICULE DE BREVET EUROPEEN

(11) **EP 3 138 179 B1**
(45) Date de publication et mention de la délivrance du brevet: **20.12.2017**
(21) Numéro de dépôt: 15717559.7
(22) Date de dépôt: 25.03.2015
(51) Int. Cl.: H02J 7/00, B60R 16/033, G01R 31/36, H01M 10/42, H01M 10/48, G01R 19/165, B60L 11/18

(54) **PROCEDE ET DISPOSITIF DE SURVEILLANCE D'UNE BATTERIE ELECTRIQUE DE VEHICULE**
VERFAHREN UND VORRICHTUNG ZUR ÜBERWACHUNG EINER FAHRZEUGBATTERIE
METHOD AND APPARATUS FOR MONITORING BATTERY OF VEHICLE

(30) Priorité: 30.04.2014 FR 1453956
(43) Date de publication de la demande: 08.03.2017
(73) Titulaire: Renault s.a.s, 92100 Boulogne-Billancourt (FR)
(72) Inventeur: GENIN-DEMURE, Sophie, F-92160 Antony (FR); SAINT-LEGER, Gérard, F-78000 Versailles (FR)
(86) Numéro de dépôt international: PCT/FR2015/050749
(87) Numéro de publication internationale: WO 2015/166153

(56) Documents cités:
- EP-A1- 1 995 123
- US-A1- 2009 027 056
- US-A1- 2010 198 536
- US-A1- 2012 169 288

## Description

L'invention est relative à un procédé de surveillance d'une batterie électrique de véhicule.

L'invention est également relative à un dispositif de surveillance d'une batterie électrique de véhicule.

L'invention est particulièrement utile pour fournir une aide à la décision à un garagiste ou à un opérateur confronté à une panne de démarrage de véhicule et pour informer un conducteur ou un utilisateur de véhicule d'une anomalie relative à la batterie électrique du véhicule.

L'invention est également particulièrement utile pour envoyer à un garagiste ou à un opérateur, ainsi qu'à un utilisateur ou un conducteur de véhicule, un avertissement, une alerte ou une indication relative à l'état de la batterie électrique servant au démarrage du véhicule.

En cas de panne immobilisant un véhicule, un garagiste ou un opérateur peut être confronté à de nombreux cas d'immobilisation de véhicule.

En cas de panne empêchant le démarrage immédiat du véhicule, l'opérateur ou le garagiste ne peut ainsi pas déterminer facilement s'il est nécessaire de remplacer la batterie actuelle par une batterie neuve, ou s'il suffit seulement de recharger la batterie actuelle si elle a été soumise à une décharge profonde.

Généralement, en l'absence d'informations suffisantes, l'opérateur ou le garagiste est conduit à remplacer la batterie actuelle par une batterie neuve, de manière à permettre un démarrage rapide du véhicule et à éviter une immobilisation dans un avenir proche. Il a cependant été constaté que, dans les trois quarts des cas, les batteries ont simplement été soumises à une décharge profonde qui ne justifie pas leur remplacement.

Par ailleurs, dans le cas de véhicules à l'arrêt, le conducteur ou l'utilisateur peut oublier d'éteindre les phares ou un autre organe consommateur d'électricité, ce qui conduit à la décharge progressive de la batterie électrique, voire jusqu'à une immobilisation du véhicule empêchant le démarrage subséquent du véhicule.

Également, dans le cas d'un véhicule endormi ne devant pas consommer de courant électrique, un défaut interne au véhicule peut conduire à une décharge indésirable de la batterie électrique. EP1995123 divulgue un procédé de surveillance d'une batterie de véhicule, comportant des étapes successives de mesure de l'état de charge de la batterie à intervalles prédéterminés, et les valeurs mesurées de l'état de charge sont comparées à un premier seuil. Un besoin est par conséquent apparu de surveiller les batteries électriques de véhicule, de manière à éviter les remplacements non nécessaires par des batteries neuves, et de permettre à un utilisateur ou à un conducteur de remédier à une décharge de la batterie électrique pouvant conduire à une immobilisation du véhicule.

Un premier but de l'invention est de remédier aux inconvénients de l'état de la technique, en proposant un nouveau procédé de surveillance d'une batterie électrique de véhicule permettant d'éviter l'immobilisation du véhicule ou d'y remédier.

Un autre but de l'invention est de proposer un nouveau dispositif de surveillance d'une batterie électrique de véhicule permettant d'éviter l'immobilisation du véhicule ou d'y remédier.

L'invention a pour objet un procédé de surveillance d'une batterie électrique de véhicule, comportant des étapes successives de mesure de l'état de charge de la batterie à intervalles prédéterminés, caractérisé par le fait que le procédé comporte en outre des étapes de comparaison des valeurs mesurées de l'état de charge de la batterie à un seuil prédéterminé et des étapes de comparaison du nombre de valeurs mesurées inférieures audit seuil prédéterminé à un nombre prédéterminé, en vue de décider du remplacement ou de la recharge de la batterie électrique, d'éviter une immobilisation du véhicule ou d'y remédier.

Selon d'autres caractéristiques alternatives de l'invention :
- le procédé comporte une étape de détermination de l'état du véhicule pour déterminer si le véhicule est électriquement endormi ou non.
- le procédé comporte une étape d'envoi d'une alerte, par exemple d'un message électronique, d'un message texte ou de tout autre type de message d'alerte à un conducteur ou utilisateur du véhicule.
- le procédé comporte une étape de détermination de possibilité de diagnostic de la batterie électrique du véhicule à l'aide d'une valise de diagnostic.
- le procédé comporte une étape de détermination et de test des dernières valeurs de voltage en circuit ouvert OCV de la batterie électrique pour savoir si les dernières valeurs de voltage en circuit ouvert sont notablement supérieures à zéro Volt ou non.
- le procédé comporte une étape de contrôle de date des derniers enregistrements à vide de l'état de charge de la batterie électrique, pour déterminer s'il convient de charger la batterie électrique ou de la remplacer par une batterie neuve.
- le procédé comporte une étape de contrôle du nombre d'étapes dans lesquelles les valeurs mesurées enregistrées de l'état de charge de la batterie électrique sont inférieures à un nombre prédéterminé, en vue de décider s'il convient de charger la batterie électrique ou de la remplacer par une batterie neuve.

L'invention est également relative à un dispositif de surveillance d'une batterie électrique de véhicule, comportant des moyens de mesures successives de l'état de charge de la batterie à intervalles prédéterminés, caractérisé par des moyens de comparaison des valeurs mesurées de l'état de charge de la batterie à un seuil prédéterminé et par des moyens de comparaison du nombre de valeurs mesurées inférieures audit seuil prédéterminé à un nombre prédéterminé, en vue de décider du remplacement ou de la recharge de la batterie électrique, d'éviter une immobilisation du véhicule ou d'y remédier.

Selon d'autres caractéristiques alternatives de l'invention :
- le dispositif comporte un bus de communication CAN apte à être relié à une valise de diagnostic et à une unité de commande de télécommunication, ladite unité de commande de télécommunication étant apte à émettre une alerte en direction d'un récepteur d'un conducteur ou utilisateur de véhicule.
- le dispositif comporte un bus de communication LIN reliant un calculateur de gestion d'énergie électrique à une batterie électrique de véhicule.

L'invention sera mieux comprise grâce à la description qui va suivre donnée à titre d'exemple non limitatif, en référence aux dessins annexés dans lesquels :
La figure 1 représente schématiquement un organigramme d'un procédé de surveillance d'une batterie électrique de véhicule.
La figure 2 représente schématiquement un organigramme d'un autre procédé de surveillance d'une batterie électrique de véhicule.
La figure 3 représente schématiquement un dispositif de surveillance d'une batterie électrique de véhicule pour mettre en oeuvre l'un des procédés de surveillance selon l'invention de la figure 1 ou de la figure 2.

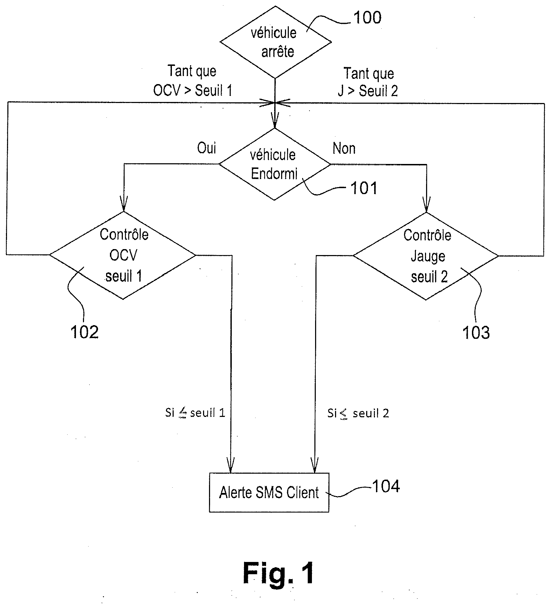

Sur la figure 1, un procédé de surveillance d'une batterie électrique de véhicule débute par une étape 100 dans laquelle le véhicule est arrêté, c'est-à-dire que le moteur à combustion interne du véhicule est à l'arrêt.

Le procédé continue à une étape 101 de vérification de l'état du véhicule, pour vérifier si le véhicule est « endormi » ou non.

L'état d'un véhicule peut être qualifié « d'endormi » si ce véhicule est en état de veille en ayant arrêté toute consommation électrique susceptible de décharger la batterie électrique du véhicule.

Si on constate à l'étape 101 que le véhicule est endormi, le procédé continue à une étape 102.

À l'étape 102, on mesure la donnée correspondant à un voltage en circuit ouvert OCV, cette donnée mesurée de voltage en circuit ouvert OCV étant enregistrée dans le calculateur de gestion d'énergie électrique du véhicule.

À l'étape 102, on compare également la donnée de voltage en circuit ouvert OCV à un premier seuil prédéterminé, par exemple de l'ordre de 12 Volt.

Si le voltage en circuit ouvert OCV est supérieur audit seuil prédéterminé, le procédé reboucle à l'étape 101 de vérification de l'état du véhicule.

Si le voltage en circuit ouvert OCV est inférieur audit seuil prédéterminé, on passe à l'étape 104 d'envoi d'une alerte au conducteur ou à l'utilisateur du véhicule. L'envoi de l'alerte peut être effectué par un message texte SMS qui aboutit sur le téléphone portable ou le smartphone du conducteur ou de l'utilisateur du véhicule.

Tout autre mode d'alerte peut également être envisagé sans sortir du cadre de la présente invention, tel qu'un message vocal, un message de courrier électronique, ou tout autre type d'envoi susceptible d'être reçu sur un récepteur de l'utilisateur ou du conducteur du véhicule.

Si, à l'étape 101, on constate que le véhicule n'est pas endormi, c'est-à-dire qu'une consommation électrique subsiste, notamment dans le cas d'un défaut électrique, on effectue un contrôle de jauge à l'étape 103.

Le contrôle de jauge est une donnée mesurée disponible dans le calculateur de gestion d'énergie électrique du véhicule. Ce contrôle de jauge correspond à l'état de charge de la batterie électrique du véhicule. Le contrôle de jauge de l'étape 103 permet de comparer la donnée disponible dans le calculateur de gestion d'énergie électrique à un autre seuil prédéterminé, par exemple de l'ordre de 7 Volt.

Si l'étape 103 détermine que la valeur de l'état de charge de la batterie SOC est inférieure à ladite valeur prédéterminée dudit autre seuil prédéterminé, on passe à l'étape 104 d'envoi d'une alerte au conducteur ou à l'utilisateur du véhicule.

Cette étape 104 correspond à l'envoi d'une alerte sur un récepteur du conducteur ou de l'utilisateur du véhicule, comme décrit précédemment, par un message texte SMS ou par tout autre mode d'alerte, tel qu'un message vocal, un message de courrier électronique, ou tout autre type d'envoi susceptible d'être reçu sur un récepteur de l'utilisateur ou du conducteur du véhicule.

Si le contrôle de jauge de l'étape 103 détermine que l'état de charge SOC de la batterie électrique du véhicule est supérieur à ladite valeur prédéterminée dudit autre seuil prédéterminé, le procédé boucle à l'étape 101 de détermination de l'état du véhicule.

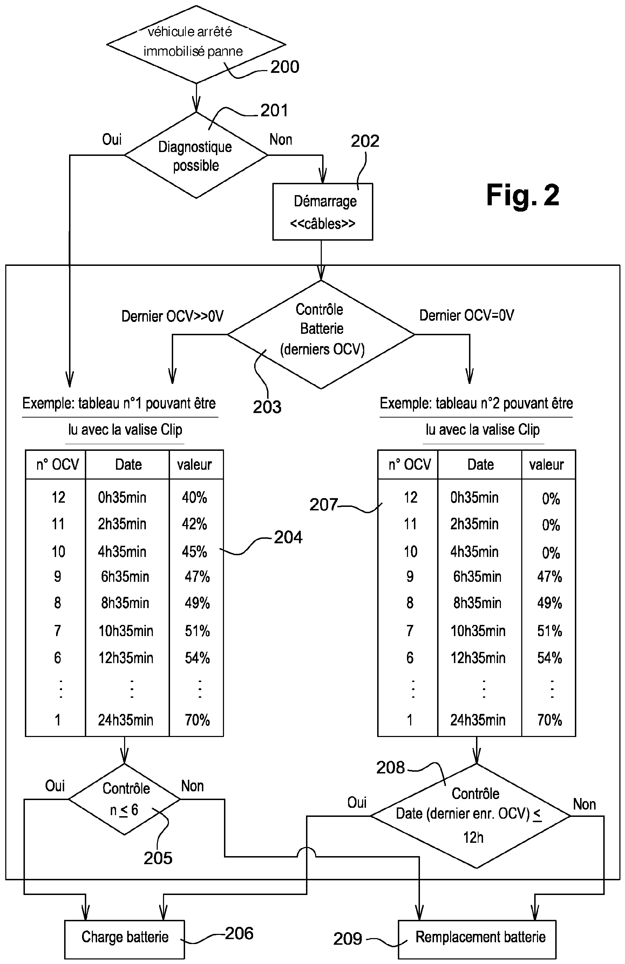

Sur la figure 2, un autre procédé de surveillance d'une batterie électrique de véhicule débute par une étape 200 dans laquelle le véhicule est arrêté, c'est-à-dire avec son moteur à l'arrêt.

Dans le cas de l'étape 200, le véhicule est susceptible d'être immobilisé en panne de démarrage, c'est-à-dire que le moteur à combustion interne ne peut plus démarrer sans aide extérieure.

On passe ensuite à une étape 201 de vérification de possibilité d'un diagnostic au moyen d'une valise de diagnostic de type connu, couramment dénommée « valise Clip » par les spécialistes.

Si l'étape 201 conduit à trouver que le diagnostic est possible à l'aide d'une valise Clip, on passe à l'étape 204 de lecture de la mémoire interne du calculateur de gestion d'énergie électrique du véhicule par la valise Clip.

À l'étape 204, la valise accède à la lecture d'un nombre prédéterminé de valeurs enregistrées de l'état de la batterie du véhicule SOC, par exemple des douze dernières valeurs enregistrées à des intervalles d'environ deux heures.

La lecture des dernières valeurs enregistrées par le calculateur de gestion d'énergie électrique permet de comparer les valeurs enregistrées à un seuil prédéterminé, par exemple de l'ordre de 12 Volt, d'état de charge SOC de la batterie électrique.

Cette comparaison s'effectue en relevant les valeurs inférieures à ce seuil prédéterminé et en enregistrant le nombre de ces valeurs inférieures audit seuil prédéterminé, par exemple de l'ordre de 12 Volt.

Le nombre de valeurs enregistrées inférieures audit seuil prédéterminé est comparé à l'étape 205 à un nombre prédéterminé, par exemple la moitié du nombre total de valeurs enregistrées.

Dans cet exemple, on vérifie si le nombre de valeurs mesurées inférieures audit seuil prédéterminé est inférieur à six parmi les douze dernières valeurs mesurées enregistrées dans le calculateur de gestion d'énergie électrique. L'invention n'est pas limitée aux valeurs, seuils et nombres donnés à titre d'exemple non limitatif, et s'étend au contraire à tous autres nombres, valeurs ou seuils compatibles avec la méthodologie de vérification selon l'invention.

Si, à l'étape 205, on constate que le nombre de valeurs mesurées inférieures au seuil prédéterminé est inférieur au nombre prédéterminé fixé, on passe à une étape 206 de recharge de la batterie.

Si le nombre de valeurs mesurées inférieures audit seuil prédéterminé est supérieur audit nombre prédéterminé, on passe à une étape 209 de remplacement de la batterie électrique par une batterie neuve.

À l'étape 201, si on constate que le diagnostic du véhicule n'est pas possible à l'aide d'une valise Clip, on passe à une étape 202 de démarrage du véhicule à l'aide d'une batterie extérieure, ou d'un appareil de démarrage en branchant le véhicule sur une batterie extérieure ou un autre moyen de démarrage électrique.

Après avoir démarré le véhicule à l'étape 202, on passe à une étape 203 de contrôle de la batterie électrique en vérifiant à l'aide de la valise Clip les valeurs enregistrées dans le calculateur de gestion d'énergie électrique.

Le contrôle des valeurs enregistrées à l'étape 203 est effectué sur les valeurs de voltage en circuit ouvert OCV.

Si on constate à l'étape 203 que les derniers voltages en circuit ouvert OCV sont notablement supérieurs à zéro Volt, on passe à l'étape 204 décrite précédemment, puis à l'étape 205 pour être orienté vers une étape 206 ou une étape 209, comme décrit précédemment.

Si le contrôle de l'étape 203 détermine que les derniers voltages en circuit ouvert OCV sont voisins de zéro Volt, on passe à une étape 207 de lecture des données enregistrées dans le calculateur de gestion d'énergie électrique.

A l'étape 207, la valise accède à la lecture d'un nombre prédéterminé de valeurs enregistrées de l'état de la batterie du véhicule SOC, par exemple des douze dernières valeurs enregistrées à des intervalles d'environ deux heures.

Le contrôle de l'étape 208 permet de comparer la date du dernier enregistrement de voltage en circuit ouvert OCV à un seuil prédéterminé, par exemple douze heures.

Si le contrôle de l'étape 208 permet de déterminer que la date du dernier enregistrement de voltage en circuit ouvert OCV est inférieure à une date prédéterminée, par exemple est inférieure à 12 heures, on passe à une étape 206 de charge de la batterie.

Si le contrôle à l'étape 208 montre que la date du dernier enregistrement de voltage en circuit ouvert OCV est supérieure à une date prédéterminée, par exemple est supérieure à douze heures, on passe à l'étape 209 de remplacement de la batterie par une batterie neuve.

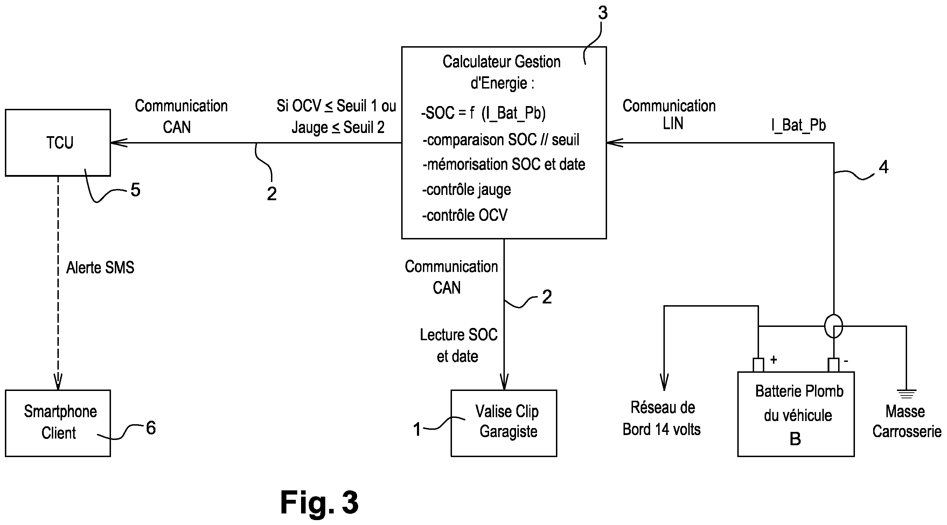

Sur la figure 3, un dispositif de surveillance de batterie électrique selon l'invention comporte une valise Clip de garagiste ou une valise 1 de diagnostic.

La valise 1 de diagnostic est reliée par un bus 2 de communication CAN à un calculateur 3 de gestion d'énergie électrique.

Les données transitant par la partie du bus 2 de communication CAN sont principalement des données temporelles et des données de lecture de valeurs mesurées d'état de charge de batterie électrique ou de voltage en circuit ouvert de la batterie électrique.

Le calculateur 3 de gestion d'énergie électrique communique avec la batterie B du véhicule par un bus de communication LIN.

Ce bus 4 de communication LIN permet au calculateur 3 de gestion d'énergie électrique d'enregistrer l'état de charge SOC de la batterie électrique comme résultant d'une fonction du courant délivré par la batterie électrique B.

Le calculateur de gestion d'énergie électrique 3 permet également d'effectuer une comparaison de l'état de charge SOC de la batterie électrique à un seuil prédéterminé choisi arbitrairement pour mettre en oeuvre le procédé décrit en référence à la figure 1 ou le procédé décrit en référence à la figure 2.

La mémorisation ou enregistrement des états de charge SOC de la batterie électrique est effectuée dans le calculateur de gestion d'énergie au moyen d'une fenêtre temporelle glissante permettant de classer par dates de mesure les valeurs mesurées et enregistrées dans le calculateur 3 de gestion d'énergie électrique.

Les valeurs correspondant au contrôle de jauge, et au contrôle de voltage en circuit ouvert OCV sont enregistrées ou mémorisées dans le calculateur 3 de gestion d'énergie électrique.

Le calculateur 3 de gestion d'énergie électrique est également relié par le bus 2 de communication CAN à une unité 5 de contrôle et de télécommunication apte à délivrer un message ou une alerte par communication sans fil à un utilisateur ou un conducteur de véhicule possédant une unité 6 de réception , par exemple un appareil portable, un smartphone ou un téléphone portable.

La communication entre le calculateur de gestion d'énergie électrique 3 par le bus 2 de communication CAN avec l'unité 5 de commande et de télécommunication est effectuée pour mettre en oeuvre le procédé selon l'invention décrit en référence à la figure 1 dans le cas où le voltage en circuit ouvert OCV est inférieur à un seuil prédéterminé ou si le contrôle de jauge révèle une valeur inférieure à un autre seuil prédéterminé.

L'invention décrite en référence à des modes de réalisation particuliers ne leur est nullement limitée, mais couvre au contraire toute modification de forme et toute variante de réalisation dans le cadre et l'esprit des revendications annexées.

## Revendications

1. Procédé de surveillance d'une batterie (B) électrique de véhicule, comportant des étapes successives de mesure de l'état de charge (SOC, OCV) de la batterie électrique à intervalles prédéterminés, et des étapes de comparaison (205, 208, 102, 103) des valeurs mesurées d'état de charge (SOC, OCV) de batterie électrique à un premier seuil prédéterminé et **caractérisé par** une étape de comparaison du nombre de valeurs mesurées inférieures audit seuil prédéterminé à un nombre prédéterminé, en vue de décider du remplacement ou de la recharge de la batterie électrique, d'éviter une immobilisation du véhicule ou d'y remédier.

2. Procédé selon la revendication 1, **caractérisé par le fait que** le procédé comporte une étape (101) de détermination de l'état du véhicule pour déterminer si le véhicule est électriquement endormi ou non.

3. Procédé selon la revendication 1 ou la revendication 2, **caractérisé par le fait que** le procédé comporte une étape d'envoi d'une alerte, par exemple d'un message électronique, d'un message texte (SMS) ou de tout autre type de message d'alerte à un conducteur ou utilisateur du véhicule.

4. Procédé selon l'une quelconque des revendications précédentes, **caractérisé par le fait que** le procédé comporte une étape (201) de détermination de possibilité de diagnostic de la batterie électrique du véhicule à l'aide d'une valise (1) de diagnostic.

5. Procédé selon la revendication 4, **caractérisé par le fait que** le procédé comporte une étape (203) de détermination et de test des dernières valeurs de voltage en circuit ouvert (OCV) de la batterie électrique pour savoir si les dernières valeurs de voltage en circuit ouvert sont notablement supérieures à zéro Volt ou non.

6. Procédé selon la revendication 4 ou la revendication 5, **caractérisé par le fait que** le procédé comporte une étape (208) de contrôle de date des derniers enregistrements à vide de l'état de charge (SOC) de la batterie électrique, pour déterminer s'il convient de charger la batterie électrique ou de la remplacer par une batterie neuve.

7. Procédé selon l'une quelconque des revendications 4 à 6, **caractérisé par le fait que** le procédé comporte une étape de contrôle (205) du nombre d'étapes dans lesquelles les valeurs mesurées enregistrées de l'état de charge (SOC, OCV) de la batterie électrique sont inférieures à un nombre prédéterminé, en vue de décider s'il convient de charger la batterie électrique ou de la remplacer par une batterie neuve.

8. Dispositif pour la mise en oeuvre d'un procédé selon l'une quelconque des revendications 1 à 7 et où le dispositif comporte des moyens (3) de mesure de l'état de charge (SOC, OCV) de la batterie électrique (B) à intervalles prédéterminés, le dispositif comportant en outre des moyens de comparaison (3) des valeurs mesurées enregistrées d'état de charge (SOC, OCV) de batterie électrique à un seuil prédéterminé, le dispositif **caractérisé par** des moyens de comparaison (3) du nombre de valeurs mesurées mémorisées inférieures audit seuil prédéterminé à un nombre prédéterminé, en vue de décider du remplacement ou de la recharge de la batterie électrique, d'éviter une immobilisation du véhicule ou d'y remédier.

9. Dispositif selon la revendication 8, **caractérisé par le fait que** le dispositif comporte un bus (2) de communication CAN apte à être relié à une valise (1) de diagnostic et à une unité (5) de commande de télécommunication, ladite unité (5) de commande de télécommunication étant apte à émettre une alerte en direction d'un récepteur (6) d'un conducteur ou utilisateur de véhicule.

10. Dispositif selon la revendication 8 ou la revendication 9, **caractérisé par le fait que** le dispositif comporte un bus (4) de communication LIN reliant un calculateur (3) de gestion d'énergie électrique à une batterie (B) électrique de véhicule.

## Patentansprüche

1. Verfahren zur Überwachung einer elektrischen Fahrzeugbatterie (B), das aufeinanderfolgende Schritte der Messung des Ladezustands (SOC, OCV) der elektrischen Batterie in vorbestimmten Zeitabständen und Schritte (205, 208, 102, 103) des Vergleichs der gemessenen Ladezustandswerte (SOC, OCV) der elektrischen Batterie mit einer ersten Schwelle aufweist, und durch einen Schritt des Vergleichs der Anzahl von gemessenen Werten unterhalb der vorbestimmten Schwelle mit einer vorbestimmten Anzahl gekennzeichnet ist, um über den Austausch oder das Aufladen der elektrischen Batterie zu entscheiden, die Stilllegung des Fahrzeugs zu vermeiden oder sie zu beheben.

2. Verfahren nach Anspruch 1, **dadurch gekennzeichnet, dass** das Verfahren einen Schritt (101) der Bestimmung des Zustands des Fahrzeugs aufweist, um zu bestimmen, ob das Fahrzeug elektrisch im Schlafmodus ist oder nicht.

3. Verfahren nach Anspruch 1 oder Anspruch 2, **dadurch gekennzeichnet, dass** das Verfahren einen Schritt des Sendens eines Alarms, zum Beispiel einer elektronischen Nachricht, einer Textnachricht (SMS) oder jeder anderen Art von Alarmnachricht an einen Fahrer oder Nutzer des Fahrzeugs aufweist.

4. Verfahren nach einem der vorhergehenden Ansprüche, **dadurch gekennzeichnet, dass** das Verfahren einen Schritt (201) der Bestimmung einer Diagnosemöglichkeit der elektrischen Batterie des Fahrzeugs mit Hilfe eines Diagnosekoffers (1) aufweist.

5. Verfahren nach Anspruch 4, **dadurch gekennzeichnet, dass** das Verfahren einen Schritt (203) der Bestimmung und des Tests der letzten Leerlaufspannungswerte (OCV) der elektrischen Batterie aufweist, um zu wissen, ob die letzten Leerlaufspannungswerte deutlich höher als Null Volt sind oder nicht.

6. Verfahren nach Anspruch 4 oder Anspruch 5, **dadurch gekennzeichnet, dass** das Verfahren einen Schritt (208) der Datumskontrolle der letzten Leeraufzeichnungen des Ladezustands (SOC) der elektrischen Batterie aufweist, um zu bestimmen, ob es sich empfiehlt, die elektrische Batterie zu laden oder sie durch eine neue Batterie zu ersetzen.

7. Verfahren nach einem der Ansprüche 4 bis 6, **dadurch gekennzeichnet, dass** das Verfahren einen Schritt der Kontrolle (205) der Anzahl von Schritten aufweist, in denen die aufgezeichneten gemessenen Werte des Ladezustands (SOC, OCV) der elektrischen Batterie niedriger als eine vorbestimmte Anzahl sind, um zu entscheiden, ob es sich empfiehlt, die elektrische Batterie zu laden oder sie durch eine neue Batterie zu ersetzen.

8. Vorrichtung zur Durchführung eines Verfahrens nach einem der Ansprüche 1 bis 7 und wobei die Vorrichtung Einrichtungen (3) zur Messung des Ladezustands (SOC, OCV) der elektrischen Batterie (B) in vorbestimmten Zeitabständen aufweist, wobei die Vorrichtung außerdem Vergleichseinrichtungen (3) der aufgezeichneten gemessenen Ladezustandswerte (SOC, OCV) der elektrischen Batterie mit einer vorbestimmten Schwelle aufweist, wobei die Vorrichtung durch Vergleichseinrichtungen (3) der Anzahl von aufgezeichneten gemessenen Werten unterhalb der vorbestimmten Schwelle mit einer vorbestimmten Anzahl gekennzeichnet ist, um über den Austausch oder das Aufladen der elektrischen Batterie zu entscheiden, eine Stilllegung des Fahrzeugs zu vermeiden oder sie zu beheben.

9. Vorrichtung nach Anspruch 8, **dadurch gekennzeichnet, dass** die Vorrichtung einen Kommunikationsbus CAN (2) aufweist, der mit einem Diagnosekoffer (1) und mit einer Telekommunikations-Steuereinheit (5) verbunden werden kann, wobei die Telekommunikations-Steuereinheit (5) einen Alarm an einen Empfänger (6) eines Fahrers oder Nutzers des Fahrzeugs senden kann.

10. Vorrichtung nach Anspruch 8 oder Anspruch 9, **dadurch gekennzeichnet, dass** die Vorrichtung einen Kommunikationsbus LIN (4) aufweist, der einen Verwaltungsrechner (3) elektrischer Energie mit einer elektrischen Batterie (B) des Fahrzeugs verbindet.

## Claims

1. Method for monitoring an electrical battery (B) of a vehicle, comprising consecutive steps of measuring the state-of-charge (SOC, OCV) of the electrical battery at predetermined intervals, and steps of comparing (205, 208, 102, 103) the measured values of the state-of-charge (SOC, OCV) of the electrical battery with a first predetermined threshold and **characterized by** a step of comparing the number of measured values below said predetermined threshold to a predetermined number, in order to decide whether to replace or recharge the electrical battery, in order to avoid or remedy an immobilization of the vehicle.

2. Method according to Claim 1, **characterized in that** the method comprises a step (101) of determining the status of the vehicle to determine if the vehicle is electrically asleep or not.

3. Method according to Claim 1 or Claim 2, **characterized in that** the method comprises a step of sending an alert, for example an e-mail, a text message (SMS) or any other type of warning message to a driver or user of the vehicle.

4. Method according to any one of the preceding claims, **characterized in that** the method comprises a step (201) of determining whether a diagnostic can be performed on the electrical battery of the vehicle using a diagnostic set (1).

5. Method according to Claim 4, **characterized in that** the method comprises a step (203) of determining and of testing the last open circuit voltage (OCV) values of the electrical battery to know whether or not the last open circuit voltage values are significantly higher than zero volts.

6. Method according to Claim 4 or Claim 5, **characterized in that** the method comprises a step (208) of controlling the date of the last recordings of the state-of-charge (SOC) of the electrical battery under no load, in order to determine if the electrical battery should be charged or if it should be replaced with a new battery.

7. Method according to any one of Claims 4 to 6, **characterized in that** the method comprises a step of controlling (205) the number of steps in which the recorded measured values of the state-of-charge (SOC, OCV) of the electrical battery are less than a predetermined number, in order to decide if the electrical battery should be charged or if it should be replaced with a new battery.

8. Device for implementing a method according to any one of Claims 1 to 7, and wherein the device comprises means (3) for measuring the state-of-charge (SOC, OCV) of the electrical battery (B) at predetermined intervals, the device further comprising means for comparing (3) the recorded measured values of the state-of-charge (SOC, OCV) of the electrical battery with a predetermined threshold, the device **characterized by** means for comparing (3) the number of stored measured values below said predetermined threshold to a predetermined number, in order to decide whether to replace or recharge the electrical battery, in order to avoid or remedy an immobilization of the vehicle.

9. Device according to Claim 8, **characterized in that** the device comprises a CAN communication bus (2) able to be connected to a diagnostic set (1) and to a telecommunication control unit (5), said telecommunication control unit (5) being able to issue an alert to a receiver (6) of a driver or vehicle user.

10. Device according to Claim 8 or Claim 9, **characterized in that** the device comprises a LIN communication bus (4) connecting an electrical power management computer (3) to an electrical battery (B) of a vehicle.
